(19) Europäisches Patentamt

European Patent Office

Office européen des brevets

(11) **EP 0 923 194 B1**

(12) **EUROPEAN PATENT SPECIFICATION**

(45) Date of publication and mention
of the grant of the patent:
**24.05.2006 Bulletin 2006/21**

(51) Int Cl.:
*H03F 5/00* (2006.01)     *H03F 3/26* (2006.01)

(21) Application number: **98309973.0**

(22) Date of filing: **04.12.1998**

(54) **Output signal converter for tube amplifiers**

Signalumwandler für Röhrenverstärker

Convertisseur de signal pour amplificateurs à tubes

(84) Designated Contracting States:
**DE GB**

(30) Priority: **04.12.1997 JP 34872997**
         **14.07.1998 JP 19903898**

(43) Date of publication of application:
**16.06.1999 Bulletin 1999/24**

(60) Divisional application:
**03019830.3 / 1 372 260**

(73) Proprietor: **Korg Inc.**
**Tokyo 168-0073 (JP)**

(72) Inventors:
• **Mori, Yasuhiko**
  **Tokyo 168-0073 (JP)**
• **Mieda, Fumio**
  **Tokyo 168-0073 (JP)**

• **Mitoma, Hirofumi**
  **Tokyo 168-0073 (JP)**

(74) Representative: **Jehan, Robert et al**
**Williams Powell**
**Morley House**
**26-30 Holborn Viaduct**
**London EC1A 2BP (GB)**

(56) References cited:
**JP-A- 9 260 959        US-A- 3 566 236**
**US-A- 5 422 599        US-A- 5 635 872**
**US-A- 5 668 499**

• **PATENT ABSTRACTS OF JAPAN vol. 006, no. 042
(E-098), 16 March 1982 (1982-03-16) -& JP 56
158509 A (YOSHIMURA MASAKI), 7 December
1981 (1981-12-07)**

EP 0 923 194 B1

**Description**

The present invention is related to an amplifier used for electronic musical instruments and audio systems, and more particularly to an output signal converter for tube amplifiers which preferably is installed on the rear side of a tube amplifier and is capable of amplifying and attenuating output signals to convert them to a range of from high output to low output while maintaining advantages in output properties of tube amplifiers.

In recent time, due to progress in the field of semiconductor technology, vacuum tube amplifiers for electronic musical instruments and audio systems being used as major in the past have been replaced by other type of amplifiers wherein semiconductor devices, such as transistors, are used. However, tube amplifiers have particular output properties which cannot be provided by amplifiers using semiconductor devices and are still acquiring persistent popularity so that a small number of tube amplifiers have been produced, sold and used yet.

As it is well-known by the majority of peoples, because of such disadvantages of a vacuum tube, when comparing with semiconductor devices, as that it has shorter life longevity, is broken more easily and less reliable, bigger and inconvenient to install, heavier, produces greater heating value, is requiring high voltage power supply, and it costs higher, it is not practically possible to use vacuum tubes for amplifiers even though there are many requests which want to use vacuum tubes for amplifiers, and therefore, it is obliged in many cases to use the amplifiers constituted with semiconductor devices.

For aiming at solving the problem as described above, many types of amplifiers which can mimetically articulate the output property of tube amplifiers by using semiconductor devices amplifier and counter electromotive force generated in a speaker affect the performance of a tube amplifier. Therefore, it will be understood that there is a limit in producing the output property obtainable in virtue of interactive relation by using an amplifier constituted with semiconductor devices. In fact, no amplifiers which can accurately imitate the output property of tube amplifiers have existed yet.

JP-A-09/260,959 discloses a direct coupled type vacuum tube amplifying circuit, to stabilize the operation and simplify the feedback loop, a plate power source which is connected to a plate of a vacuum tube of a first stage through a constant current source. A grid of a vacuum tube of a next stage is connected to the plate of the vacuum tube through a first resistance. A second resistance is connected between the grid and the cathode of the vacuum tube. A negative power source is connected to the resistance through a constant current source. In this constitution, the grid bias voltage of the second vacuum tube is defined by the voltage drop of the second resistance.

According to the present invention there is provided an output signal converter for tube amplifiers as specified in claim 1.

The preferred embodiments can provide an output signal converter for tube amplifiers in which output signals of predetermined power level can be obtained from those of the tube amplifiers containing a minimum number of vacuum tubes by converting the output signals by means of using semiconductor devices while maintaining output properties including transformer property and speaker property obtainable when using tube amplifiers.

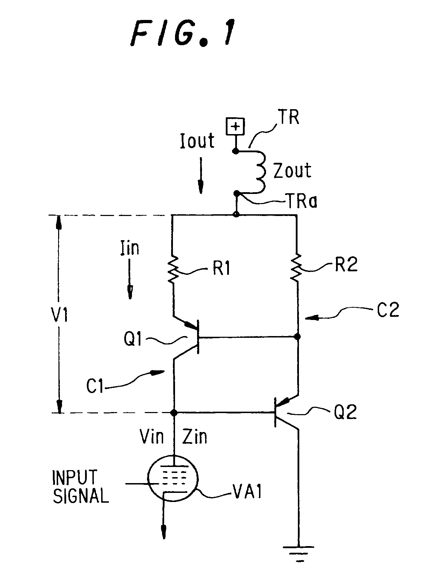

Now, a preferable embodiment of the present invention will be described with reference to FIG.1. In the output signal converter according to the present invention, signals output from a vacuum tube VA1 flow through a first circuit C1. Besides, electric current proportioned to the current level flowing through the first circuit C1 flows into a second circuit C2 which is connected in parallel to the first circuit C1. The ratio of current value flown through the first circuit C1 versus current value flown through the second circuit C2 is determined depending upon the ratio of a first resistance R1 and a second resistance R2. For example, if R1 and R2 are equal in resistance value, current equivalent to the current flown through the first circuit C1 is supposed to flow through the second circuit C2. Consequently, electric current having amplified output signal from the vacuum tube VA1 to double level flows into the primary side of an output transformer TR, and the output property from the vacuum tube VA1 is maintained in the output signal. Therefore, by using one vacuum tube, it is allowed to obtain output signals which might be obtainable when using two vacuum tubes. Based on the embodiment as described above, particular output properties produced by using a vacuum tube can be obtained in large scale by means of using a minimum number of vacuum tubes, which have such disadvantages as that it has shorter longevity, broken easily, and inconvenient to install, and by using semiconductor devices for all other circuits.

An embodiment of the present invention is described below, by way of example only, with reference to the accompanying drawings, in which:

Fig. 1 is a circuit diagram showing the constituion of an output signal converter for tube amplifiers according to a first embodiment of the present invention.
Fig. 2 is a circuit diagram showing the consitution of the output signal converter for tube ampliers according to a second embodiment of the present invention.
FIG.3 is a circuit diagram showing the constitution of the output signal converter for tube amplifiers according to a third embodiment of the present invention.
FIG.4 is a explanatory diagram showing output properties obtained when using the preferred output signal converters wherein FIG.4A shows a sine wave to be Iiput, FIG.4B shows a wave form of an output signal when input the sine wave into an amplifier constituted by using semiconductor devices only, FIG.4C shows a wave form of an output signal when input the sine wave into a tube amplifier, and FIG.4D shows a wave form of an output signal when input the sine wave into the circuit shown in FIG.2.

FIG.5 is a circuit diagram showing the constitution of the output signal converter for tube amplifiers according to a forth embodiment of the present invention, and it is an example of an application for a push-pull amplifier.

FIG.6 is an explanatory diagram showing output properties when using the circuit shown in FIG.5, wherein FIG.6A shows a sine wave to be input, FIG.6B shows a wave form of an output signal when input the sine wave into a push-pull amplifier containing four vacuum tubes, and FIG.6C shows a wave form of an output signal when input the sine wave into the circuit shown in FIG.5.

FIG.1 is a circuit diagram showing an output signal converter for tube amplifiers according to a first embodiment of the present invention. With this output signal converter, it is possible to amplify output signals obtained from one vacuum tube VA1 maintaining its output property to thereby obtain output signals as if they are the ones having been obtained by using a plurality of vacuum tubes.

As shown in FIG.1, the output signal converter is provided on a site between a plate terminal of a vacuum tube VA1 and one of input terminals TRa of an output transformer TR and is constituted with a first circuit C1 which is formed by connecting a first resistance R1 and a first transistor Q1 in series and a second circuit C2 which is formed by connecting a second resistance R2 and a second transistor Q2 in series.

Namely, the terminal TRa is branched into two systems, and one of the systems (the first circuit C1) is connected to an emitter of the first transistor Q1 via the first resistance R1, and a collector of the transistor Q1 is connected to the plate terminal of the vacuum tube VA1. Whereas, the other system (the second circuit C2) is connected to an emitter of the second transistor Q2 via the second resistance R2, and a collector of the second transistor Q2 is connected to the ground. Further, a base of the first transistor Q1 is connected to the emitter of the second transistor Q2, and a base of the second transistor Q2 is connected to the plate terminal of the vacuum tube VA1.

Now, detailed performance of the output signal converter as constituted above is explained below. Here, current flowing into the primary side of the transformer TR is defined as Iout, current flowing into the first circuit C1 is defined as Iin, voltage between the plate terminal of the vacuum tube VA1 and the input terminal TRa of the transformer TR is defined as V1, an impedance of the load side viewed from the transformer TR is defined as Zout, and an impedance of the load side viewed from the vacuum tube VA1 is defined as Zin. Here, the following equations (1) to (3) can be given:

$$\mathrm{Iout\ =\ Vin\ /\ (Zout\ +\ R1//R2)\ \ldots\ldots\ (1)}$$

Provided that R1//R2 represents parallel resistance of the resistance R1 and the resistance R2 (R1 * R2 / R1 + R2).

$$\mathrm{V1\ =\ R1//R2\ *\ Iout\ \ldots\ldots\ (2)}$$

$$\mathrm{Iin\ =\ V1/R1\ \ldots\ldots\ (3)}$$

And, an equation (4) is obtained based on equations (2) and (3):

$$\mathrm{Iin\ =\ [(R1//R2)/R1]\ *\ Iout\ \ldots\ldots\ (4)}$$

Further, an equation, Iin = Vin/Zin, is applied into an equation (4), and an equation (1) is also applied into the equation (4), thereby the following equation (5) can be given:

$$\mathrm{Vin/Zin\ =\ [(R1//R2)/R1]\ *\ Vin/[Zout\ +\ (R1//R2)]\ldots\ldots\ (5)}$$

By modifying the equation (5) and developing R1//R2, the following equation (6) can be given:

3

$$Zin = [(R1+R2)/R2] * [Zout + \{(R1*R2)/(R1+R2)\}] \ldots \ldots \ldots (6)$$

In the equation (6), when applying such condition as R1<<Zout and R2<<Zout, the following equation (7) can be given:

$$Zin = [(R1+R2)/R2] * Zout \ldots \ldots (7)$$

From the equation (7), it will be understood that Zin and Zout are determined according to a ratio of the first resistance R1 and the second resistance R2. For example, when R1 = R2 is given, an equation, Zout = (1/2)Zin is lead, and the impedance comes to 1/2. Therefore, current output of the transformer TR becomes to a double value, which shows that output signals produced by the vacuum tube VA1 be amplified to a double level of the current output. In addition, current flowing into the second circuit C2, which is a circuit formed with the second resistance R2 and the second transistor Q2, comes to an equivalent value as the current flowing into the first circuit C1 so that Iout comes to a double value of Iin which apparently maintain the output property given by the vacuum tube VA1. As a result, it is allowed to obtain output signals, of which properties are the ones as if produced by two vacuum tubes, by using only one vacuum tube.

Also, by appropriately changing a ratio of the first resistance R1 and the second resistance R2, it is possible to change current amplification rate. For example, if R2 = 2 * R1 is given, it is possible to triple the value of Iout relative to the value of Iin, and if R2 = (1/2) * R1 is given, it is possible to make a value of Iout to a 1.5 times value of Iin.

As described above, according to the output signal converter shown in FIG.1, it is allowed to obtain output signals, of which property is similar to the one obtainable by using more than 1 vacuum tube, by using just one vacuum tube VA1, and therefore, it becomes feasible to reduce the number of vacuum tubes to be provided, which have such disadvantages as that it produces greater heating value, requires high voltage power supply, costs more, and has shorter longevity, to a minimum number. It is very advantageous to use the output signal converter according to the present invention for amplifiers in use for guitars and audio systems.

Whereas, although a resistance R2 of which value being fixed is used in FIG. 1, when a variable resistance R2 is given, it is allowable to adjust the current value of Iout by controlling resistance value of the variable resistance to thereby allow to optionally control increase and reduction of output sound volume. Although sound volume control is normally operated at the input side, namely at the prior stage to the vacuum tube VA1 in FIG.1, it is possible to adjust the sound volume with keeping the current Iin flowing into the vacuum tube VA1 at a substantially-fixed level by adopting a method to control resistance value of the second resistance R2, which allows to control the sound volume with keeping the output property produced by vacuum tubes.

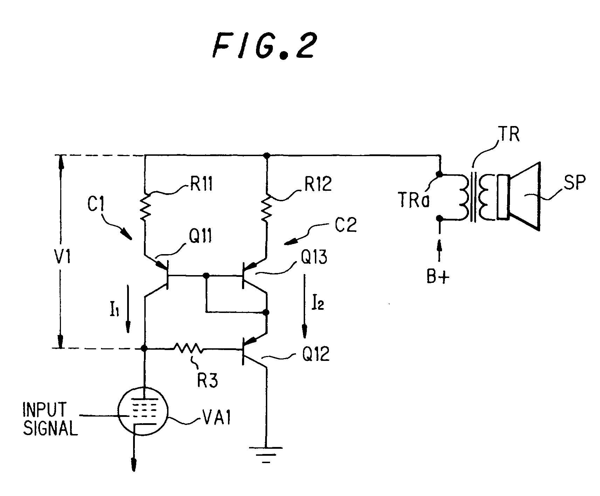

FIG.2 is a circuit diagram showing the constitution of the output signal converter for tube amplifiers according to a second embodiment of the present invention. As shown in FIG.2, the output signal converter is constituted of an output transformer TR, resistances R11, R12 and R3, and transistors Q11, Q12 and Q13. A connecting cable being connected to one of input terminals of the output transformer TR is branched into two systems, and one of the branches (a first circuit C1) is connected to a plate terminal of a vacuum tube VA1 via the first resistance R11 and, an emitter and a collector of the first transistor Q11, while the other branch (a second circuit C2) is connected to the ground via the second resistance R12, an emitter and a collector of the third transistor Q13, and further an emitter and a collector of the second transistor Q12. Further, a base of the first transistor Q11 and a base of the third transistor Q13 are connected, and this node is further connected to a collector of the second transistor Q12. Therefore, a current mirror circuit is formed with the first transistor Q11 and the third transistor Q13. Whereas, a base of the second transistor Q12 is connected to the plate terminal of the vacuum tube VA1 via the resistance R3, and a speaker SP is connected to the output side of the output transformer TR.

In the embodiment shown in FIG.2, because of formation of the current mirror circuit formed with the first transistor Q11 and the third transistor Q13, current directly imitating the property of the first transistor Q11, such as temperature characteristic, flow into the second circuit, and therefore, it is allowed to obtain output signals having fidelity to the output property produced by the vacuum tube VA1.

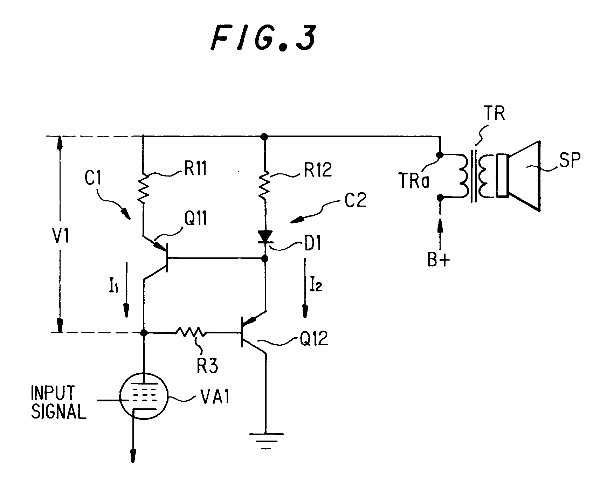

FIG.3 is a circuit diagram showing the output signal converter according to a third embodiment of the present invention. As shown in FIG.3, a diode D1 is used as the substitute for the third transistor Q13 in the output signal circuit shown in FIG.2. According to this type of constitution, although performance stability gets worse in comparison with that in the output signal converting circuit as shown in FIG.2, simplification of a circuit is allowable up to an extent that is obtainable by using a diode as a substitute of a transistor.

**EP 0 923 194 B1**

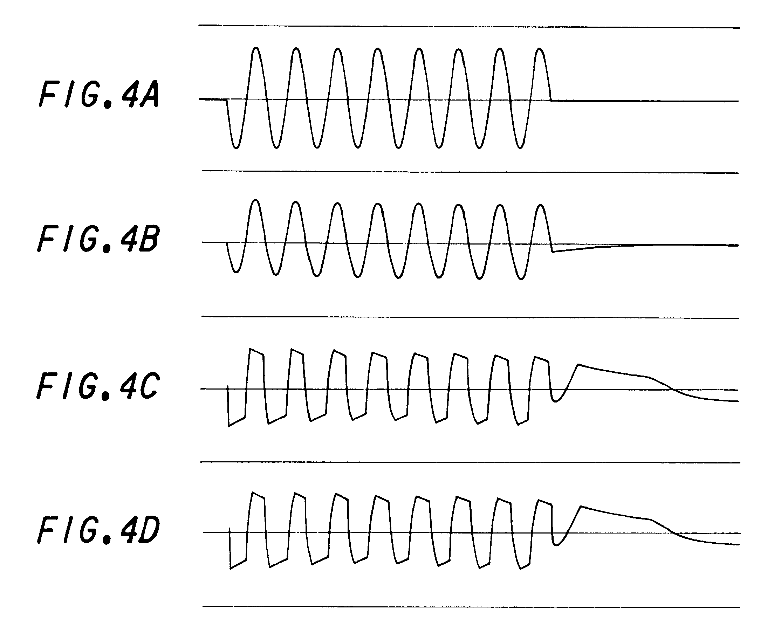

FIG.4 is an explanatory diagram showing different wave forms, wherein FIG.4A shows a wave form of a sine wave as an input signal, FIG.4B shows an output wave form when amplified the sine wave signal shown in FIG.4A by using an amplifier constituted with semiconductor devices, FIG.4C shows an output wave form when amplified the sine wave shown in FIG.4A by using a conventional tube amplifier (an amplifier constituted with a plurality of vacuum tubes), and FIG.4D shows an output wave form when amplified the sine wave signal shown in FIG.4A by using the output signal converting circuit shown in FIG.2. As easily understood from FIG.4B, contrary to that the output wave form which substantially-truly presents the sine wave to be input is obtainable by using the amplifier containing semiconductor devices, the output wave form specifically produced by the tube amplifier is obtainable when using the conventional tube amplifier as shown in FIG.4C.

When amplifying the sine wave shown in FIG.4A by using the output signal converter shown in FIG.2, it is possible to obtain output signals which are substantially equivalent to the output wave form obtainable by using a conventional tube amplifier as shown in FIG.4D, thus it will be understood that the output signal converter of the present invention is truly reproducing the output property given by a vacuum tube.

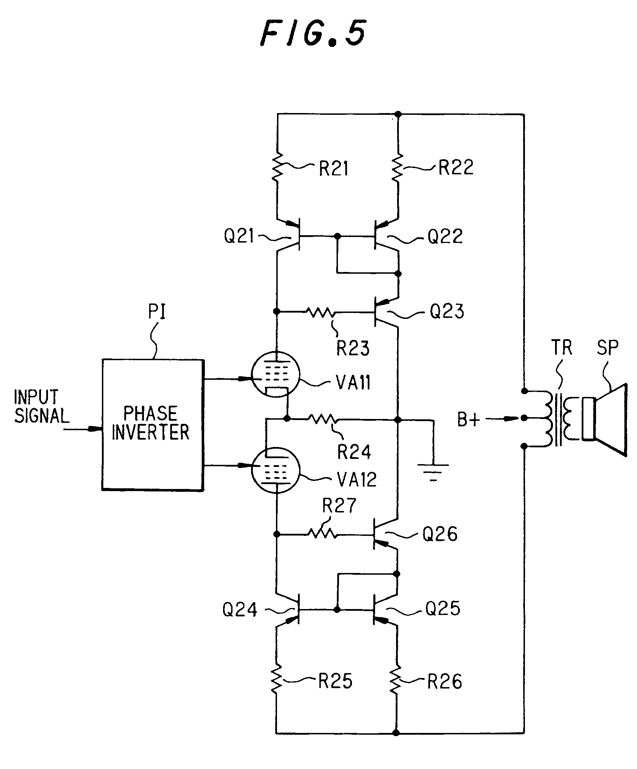

FIG.5 is a circuit diagram showing the constitution of the output signal converter according to a forth embodiment. As shown in FIG.5, a push-pull amplifier is constituted with two vacuum tubes VA11 and VA12 in the output signal converter. In brief, two circuits each using a current mirror shown in FIG.2 are provided symmetrically at both upper and lower sites, each cathodes of the two vacuum tubes VA11 and VA12 are connected and a node thereof is connected to the ground via resistance R24.

As it is well known, push-pull type power amplification is an output system which separates sound signals produced by a preamplifier into positive and negative signals by using a phase inverter PI, amplifying the positive side signals at an upper circuit (i.e. a circuit containing Q21, Q22, Q23, etc.) provided with the vacuum tube VA11, amplifying the negative side signals at a lower circuit (i.e. a circuit containing Q24, Q25, Q26, etc.) provided with vacuum tube VA12, and composing such signals at the output transformer TR and outputting them through the speaker SP. With the constitution as described above, as two vacuum tubes VA11 and VA12 are used therein, it is possible to obtain output property equivalent to the one obtainable by a push-pull type tube amplifier containing many vacuum tubes.

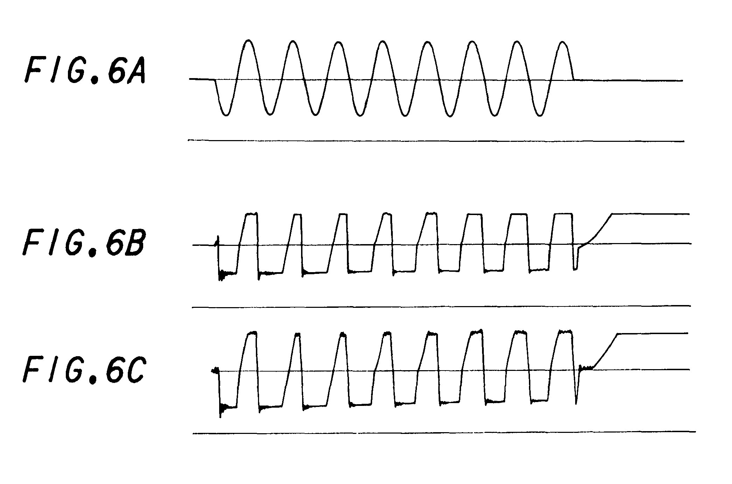

FIG.6 shows a wave form showing the output property of the push-pull type amplifier shown in FIG.5, wherein FIG.6A shows a sine wave as an input signal, FIG.6B shows an output wave form when applying the sine wave shown in FIG.6A into an amplifier constituted with four vacuum tubes, namely a conventional push-pull type tube amplifier, and FIG.6C shows an output wave form when applying the sine wave shown in FIG.6A into the amplifier shown in FIG.5. As easily understood from FIGs.6B and 6C, it is confirmable that the output signal converter shown in FIG.5 can truly reproduce the output property produced by a vacuum tube, because it is demonstrated that substantially-equivalent wave forms are obtainable from the comparison of the wave forms obtainable by using a conventional push-pull type amplifier containing many vacuum tubes with the ones obtainable by using an amplifier containing a minimum number of vacuum tubes.

While the invention has been particularly shown and described with reference to preferred embodiments thereof, it will be understood by those skilled in the art that various changes in form and details may be made therein without departing from the scope of the invention.

**Claims**

1. An output signal converter for tube amplifiers comprising:

a first circuit (C1) connected on a site between an input terminal (Tra) of an output transformer and an output terminal (VA1) of a tube amplifier, the first circuit (C1) being a series connecting circuit of a first resistance (R1,R11,R21) and a first transistor (Q1,Q11,Q21);
a second circuit (C2) connected to the input terminal (Tra) of the output transformer and arranged in parallel to the first circuit and operable to generate electric current proportional to a current level flowing in the first circuit, the second circuit (C2) being a series connecting circuit of a second resistance (R2,R12,R22) and a second transistor (Q2,Q12,Q23);
a base terminal of the first transistor (Q1) is connected to a node of the second resistance (R2,R12,R22) and the second transistor (Q25,Q12,Q23); and
a base terminal of the second transistor (Q2,Q12,Q23) is connected to a node of the first transistor (Q1,Q11,Q21) and the output terminal of the tube amplifier (VA1);

said output signal converter being provided on the site between the tube amplifier having the output terminal and the output transformer having the input terminal, and being formed by using semiconductor devices so that output signals can be amplified while maintaining the output property of the output signals of the tube amplifier.

5

**2.** An output signal converter as in claim 1, in which a third transistor (Q13), which forms a current mirror circuit with the first transistor (Q11), is arranged on a site between the second resistance and the second transistor.

**3.** An output signal converter as in claim 1, in which a diode (D1) is arranged on a site between the second resistance and the second transistor.

**4.** An output signal converter as in any one of claims 1 to 3, in which the second resistance is a variable resistance.

**5.** An output signal converter as in claim 1, wherein the first circuit is connected to a site between a first input terminal of an output transformer and an output terminal of the first vacuum tube (VA11),; the converter including:

a third circuit connected to a site between a second input terminal of the output transformer and an output terminal of a second vacuum tube (VA12), the third circuit being a series connecting circuit of a third resistance and a third transistor;
a fourth circuit connected to the second input terminal of the output transformer, arranged in parallel to the third circuit and operable to generate electric current proportional to a current level flowing in the third circuit, the fourth circuit being a series connecting circuit of a fourth resistance and a fourth transistor;
a base terminal of the third transistor is connected to a node of the fourth resistance and the fourth transistor;
a base terminal of the fourth transistor is connected to a node of the third transistor and the output terminal of the second vacuum tube;

said output signal converter being provided on a site between the tube amplifier having the first vacuum tube and the second vacuum tube and the output transformer having the first input terminal and the second input terminal.

**6.** An output signal converter for tube amplifiers as in claim 5, in which:

a fifth transistor (Q22) forming a current mirror circuit on a site between itself and the first transistor (Q21) is arranged on a site between the second resistance (R22) and the second transistor (Q23); and
a sixth transistor (Q25) forming a current mirror circuit on a site between itself and the third transistor (Q24) is arranged on a site between the fourth resistance (R26) and the fourth transistor (Q26).

**7.** An output signal converter as in claim 5, in which a first diode is arranged on a site between the second resistance (R22) and the second transistor (Q23), and a second diode is arranged on a site between the fourth resistance (R26) and the fourth transistor (Q26).

**8.** An output signal converter according to any one of claims 5 to 7, in which both of the second resistance (R22) and the fourth resistance (R26) are variable resistances.

**Patentansprüche**

**1.** Ein Ausgangssignalumwandler für Röhrenverstärker, beinhaltend:

einen ersten Schaltkreis (C 1), der an einer Stelle zwischen einem Eingangsanschluss (Tra) eines Ausgangstransformators und einem Ausgangsanschluss (VA 1) eines Röhrenverstärkers verbunden ist, wobei der erste Schaltkreis (C 1) ein hintereinander geschalteter Kreis eines ersten Widerstandes (R 1, R 11, R 21) und eines ersten Transistors (Q 1, Q 11, Q 21) ist;
einen zweiten Schaltkreis (C 2), der mit dem Eingangsanschluss (Tra) des Ausgangstransformators verbunden ist und parallel zum ersten Schaltkreis angeordnet ist und in Funktion zur Erzeugung eines elektrischen Stromes, proportional zu einem Strompegel, ist, der im ersten Schaltkreis fliesst, wobei der zweite Schaltkreis (C 2) ein hintereinander geschalteter Kreis eines zweiten Widerstandes (R 2, R 12, R 22) und eines zweiten Transistors (Q 2, Q 12, Q 22) ist;
einen Basisanschluss des ersten Transistors (Q 1), der mit einem Knotenpunkt des zweiten Widerstandes (R 2, R 12, R 22) und dem zweiten Transistor (Q 25, Q 12, Q 23) verbunden ist; und
einen Basisanschluss des zweiten Transistors (Q 2, Q 12, Q 23, der mit einem Knotenpunkt des ersten Transistors (Q 1, Q 11, Q 21) und dem Ausgangsanschluss des zweiten Röhrenverstärkers (VA 1) verbunden ist;
der Ausgangssignalumwandler ist an der Stelle zwischen dem Röhrenverstärker, der den Ausgangsanschluss hat und dem Ausgangstransformator, der den Eingangsanschluss hat, angeordnet und unter Einsatz von Halbleitervorrichtungen ausgebildet, so dass die Ausgangssignale verstärkt werden können, während die Ausgangseigenschaft der Ausgangssignale des Röhrenverstärkers beibehalten werden.

**2.** Ein Ausgangssignalumwandler nach Anspruch 1,
in dem ein dritter Transistor (Q 13), der einen Stromspiegelschaltkreis mit dem ersten Transistor (Q 13) bildet, an einer Stelle zwischen dem zweiten Widerstand und dem zweiten Transistor angeordnet ist.

**3.** Ein Ausgangssignalumwandler nach Anspruch 1,
in dem eine Diode (D 1) an einer Stelle zwischen dem zweiten Widerstand und dem zweiten Transistor angeordnet ist.

**4.** Ein Ausgangssignalumwandler nach den Ansprüchen 1 bis 3,
in dem der zweite Widerstand ein veränderbarer Widerstand ist.

**5.** Ein Ausgangssignalumwandler nach Anspruch 1,
in dem der erste Schaltkreis mit einer Stelle zwischen einem ersten Eingangsanschluss eines Ausgangstransformators und einem Ausgangsanschluss der ersten Vakuumröhre (VA 11) verbunden ist, wobei der Umwandler beinhaltet:

einen dritten Schaltkreis, der mit einer Stelle zwischen einem zweiten Eingangsanschluss des Ausgangstransformators und einem Ausgangsanschluss einer zweiten Vakuumröhre (VA 12) verbunden ist, wobei der dritte Schaltkreis ein hintereinander geschalteter Kreis eines dritten Widerstandes und einem dritten Transistor ist;
einen vierten Schaltkreis, der mit dem zweiten Eingangsanschluss des Ausgangstransformators verbunden ist, parallel zum dritten Schaltkreis angeordnet ist und in Funktion zur Erzeugung eines elektrischen Stromes, proportional zu einem Strompegel, ist, der im dritten Schaltkreis fliesst, wobei der vierte Schaltkreis ein hintereinander geschalteter Kreis eines vierten Widerstandes und eines vierten Transistors ist;
einen Basisanschluss des dritten Transistors, der mit einem Knotenpunkt des vierten Widerstandes und dem vierten Transistor verbunden ist;
einen Basisanschluss des vierten Transistors, der mit einem Knotenpunkt des dritten Transistors und dem Ausgangsanschluss der zweiten Vakuumröhre verbunden ist;
den Ausgangssignalumwandler, der an einer Stelle zwischen dem Röhrenverstärkter mit der ersten Vakuumröhre und der zweiten Vakuumröhre und dem Ausgangstransformator mit dem ersten Eingangsanschluss und dem zweiten Eingangsanschluss angeordnet ist.

**6.** Ein Ausgangssignalumwandler für Röhrenverstärker nach Anspruch 5,
in dem
ein fünfter Transistor (Q 22), der einen Stromspiegelschaltkreis an einer Stelle zwischen sich selbst und dem ersten Transistor (Q 21) bildet, an einer Stelle zwischen dem zweiten Widerstand (R 22) und dem zweiten Transistor (Q 23) angeordnet ist; und
ein sechster Transistor (Q 25), der einen Stromspiegelschaltkreis an einer Stelle zwischen sich selbst und dem dritten Transistor (Q 24) bildet, an einer Stelle zwischen dem vierten Widerstand (R 26) und dem vierten Transistor (Q 26) angeordnet ist.

**7.** Ein Ausgangssignalumwandler nach Anspruch 5,
in dem eine erste Diode an einer Stelle zwischen dem zweiten Widerstand (R 22) und dem zweiten Transistor (Q 23) angeordnet ist und eine zweite Diode an einer Stelle zwischen dem vierten Widerstand (R 26) und dem vierten Transistor (Q 26) angeordnet ist.

**8.** Ein Ausgangssignalumwandler nach den Ansprüchen 5 bis 7,
in dem sowohl der zweite Widerstand (R 22) als auch der vierte Widerstand (R 26) veränderbare Widerstände sind.

**Revendications**

**1.** Convertisseur de signal de sortie pour amplificateurs à tube comprenant :

un premier circuit (C1) connecté en un site entre une borne d'entrée (Tra) d'un transformateur de sortie et une borne de sortie (Va1) d'un amplificateur à tube, le premier circuit (C1) étant un circuit connecté en série composé d'une première résistance (R1, R11, R21) et d'un premier transistor (Q1, Q11, Q21) ;

un deuxième circuit (C2) connecté à la borne d'entrée (Tra) du transformateur de sortie et agencé en parallèle au premier circuit et utilisable pour générer du courant électrique proportionnel à un niveau de courant circulant dans le premier circuit, le deuxième circuit (C2) étant un circuit connecté en série composé d'une deuxième résistance (R2, R12, R22) et d'un deuxième transistor (Q2, Q12, Q23) ;

une borne de la base du premier transistor (Q1) est connectée à un noeud formé par la deuxième résistance (R2, R12, R22) et le deuxième transistor (Q25, Q12, Q23) ; et

une borne de la base du deuxième transistor (Q2, Q12, Q23) est connectée à un noeud formé par le premier transistor (Q1, Q11, Q21) et la borne de sortie de l'amplificateur à tube (Va1) ;

ledit convertisseur de signal de sortie étant fourni sur le site entre l'amplificateur à tube ayant la borne de sortie et le transformateur de sortie ayant la borne d'entrée, et étant formé en utilisant des dispositifs à semi-conducteur de façon que les signaux de sortie puissent être amplifiés tout en conservant les propriétés de sortie des signaux de sortie de l'amplificateur à tube.

2. Convertisseur de signal de sortie selon la revendication 1, dans lequel un troisième transistor (Q13), formant un circuit de miroir de courant avec le premier transistor (Q11), est agencé sur un site entre la deuxième résistance et le deuxième transistor.

3. Convertisseur de signal de sortie selon la revendication 1, dans lequel une diode (D1) est agencée sur un site entre la deuxième résistance et le deuxième transistor.

4. Convertisseur de signal de sortie selon l'une quelconque des revendications 1 à 3, dans lequel la deuxième résistance est une résistance variable.

5. Convertisseur de signal de sortie selon la revendication 1, dans lequel le premier circuit est connecté à un site entre la première borne d'entrée d'un transformateur de sortie et la borne de sortie d'un premier tube à vide (VA11), : le convertisseur incluant :

un troisième circuit connecté à un site entre une deuxième borne d'entrée du transformateur de sortie et une borne de sortie d'un deuxième tube à vide (VA12), le troisième circuit étant un circuit connecté en série composé d'une troisième résistance et d'un troisième transistor,

un quatrième circuit connecté à la deuxième borne d'entrée du transformateur de sortie, agencé en parallèle au troisième circuit et pouvant fonctionner pour générer du courant électrique proportionnel à un niveau de courant circulant dans le troisième circuit, le quatrième circuit étant un circuit connecté en série composé d'une quatrième résistance et d'un quatrième transistor ;

une borne de la base du troisième transistor est connectée à un noeud formé par la quatrième résistance et le quatrième transistor ;

une borne de la base du quatrième transistor est connectée à un noeud formé par le troisième transistor et la borne de sortie du deuxième tube à vide ;

ledit convertisseur de signal de sortie étant fourni sur un site entre l'amplificateur à tube ayant le premier tube à vide et le deuxième tube à vide et le transformateur de sortie ayant la première borne d'entrée et la deuxième borne d'entrée.

6. Convertisseur de signal de sortie pour amplificateur à tube selon la revendication 5, dans lequel :

un cinquième transistor (Q22) formant un circuit de miroir de courant sur un site entre lui-même et le premier transistor (Q21) est agencé sur un site entre la deuxième résistance (R22) et le deuxième transistor (Q23) ; et un sixième transistor (Q25) formant un circuit de miroir de courant sur un site entre lui-même et le troisième transistor (Q24) est agencé sur un site entre la quatrième résistance (R26) et le quatrième transistor (Q26).

7. Convertisseur de signal de sortie selon la revendication 5, dans lequel une première diode est agencée sur un site entre la deuxième résistance (R22) et le deuxième transistor (Q23), et une deuxième diode est agencée sur un site entre la quatrième résistance (R26) et le quatrième transistor (Q26).

8. Convertisseur de signal de sortie selon l'une quelconque des revendications 5 à 7, dans lequel à la fois la deuxième résistance (R22) et la quatrième résistance (R26) sont des résistances variables.

## FIG.1

# FIG.2

# FIG.3

FIG. 4A

FIG. 4B

FIG. 4C

FIG. 4D

# FIG.5

FIG.6A

FIG.6B

FIG.6C